Europäisches Patentamt

European Patent Office

Office européen des brevets

(11) Publication number: **0 373 794**
**A2**

## EUROPEAN PATENT APPLICATION

(21) Application number: **89312462.8**

(22) Date of filing: **30.11.89**

(51) Int. Cl.⁵: **H03K 17/66**

(30) Priority: **13.12.88 US 283645**

(43) Date of publication of application:
**20.06.90 Bulletin 90/25**

(84) Designated Contracting States:
**DE FR GB**

(71) Applicant: **Hewlett-Packard Company**
**3000 Hanover Street**
**Palo Alto California 94304(US)**

(72) Inventor: **King, Philip N.**
**1701 Rushwood Court**
**Fort Collins Colorado(US)**

(74) Representative: **Colgan, Stephen James et al**
**CARPMAELS & RANSFORD 43 Bloomsbury**
**Square**
**London WC1A 2RA(GB)**

(54) Driver circuit for in circuit tester.

(57) A driver circuit (10) for use in an overdrive/functional tester, which tester provides a control signal representative of a command for the driver circuit to provide logic signals, is shown to include a driver (20,22) for providing desired logic signals in response to an actuation signal and a pre-driver means (16,18), connected to receive the control signal and to the driver for generating an actuation signal in response to the control signal. The pre-driver stage is described as having two fast, gold doped, switching transistors (20,22).

FIG. 1

## DRIVER CIRCUIT FOR IN CIRCUIT TESTER

Field of the invention

The present invention relates to the field of circuit testing and more particularly to the field of "in-circuit" testing of digital devices and "functional" testing of digital devices.

Background of the Invention

As the use and complexity of digital circuits has increased in approximately the last decade, so also has the need to test such circuits increased in order to ensure proper operation. Basically, two types of digital circuit test techniques have been developed, namely functional test techniques and so-called in-circuit test techniques.

In functional test techniques a known digital pattern is applied to the circuit input and a comparison is made of the circuit output with an expected output. The differences between the actual and expected outputs provides an indication of circuit operation. Unfortunately, this technique is only useful when it is desirable to know the overall operation of a circuit, for example a circuit which has been assembled onto a printed circuit board. Very often it is necessary to test individual circuit elements or groups of elements which have been assembled onto a printed circuit board apart from the overall circuit operation.

In in-circuit testing techniques, testing is performed on a circuit element or elements isolated from the remainder of the circuit. In-circuit testing techniques generally involve the application of a preselected digital pattern to the input of an individual circuit element, a so-called device under test (DUT), and the comparison of the DUT response to an expected response. Since the circuit element or elements under test typically are connected to other circuit elements, it is required to overdrive any digital pattern or signal which is being applied by an "upstream" circuit element or logic device. Upstream logic devices are those devices whose outputs normally drive the inputs of the DUT. An overdrive signal is a signal which is superimposed at a selected location in a circuit.

In relation to such in-circuit testing several devices have been described. U.S. Patent No. 3,781,689 discloses a pulse generator which provides three output states for use in an in-circuit probe, namely logic high, logic low and an "off" state, the so-called tri-state. U.S. Patent No. 3,965,468 also discusses a probe for use in an in-circuit testing system where various logic patterns or signals are generated and a flashing light indicates the particular pattern or signal being applied. While hand held probe-type devices, or systems incorporating hand held probes, are convenient in-circuit testing tools, they are too time consuming if many tests are required. For example, if in-circuit testing was performed on a complex printed circuit board for quality control purposes, a hand held probe approach to in-circuit testing would be too time consuming.

In order to perform multiple simultaneous in-circuit tests on several individual circuit elements mounted on a single printed circuit board, test devices such as that disclosed in U.S. Patent No. 4,588,945 were developed. In such devices a printed circuit board having circuit elements mounted thereon is in turn mounted or affixed to a so-called bed of nails. Each nail acts as an individual probe either providing a preselected signal to or receiving an output signal from a DUT. As described in that patent, a controller module applies multiple pregenerated signal patterns to multiple DUTs through a driver module. The DUT responses are received through a sensor module and compared to expected responses.

Although it was recognized that while the driver module was to have the ability of overdriving control signals from upstream devices, damage to individual DUTs or to upstream devices could result from such overdriving. The need for in-circuit testing devices, nevertheless, remained high for three primary reasons. First, such testing techniques were effective in finding faults which occur most commonly during circuit board assembly, i.e. solder shorts, wrongly inserted components, damaged or marginal components, missing components. Second, in-circuit testing can be easily accomplished in the sense that pregenerated test patterns could be stored in memory libraries so that a test program could include a series of already generated and stored patterns. Finally, in-circuit testing remained popular because it inherently produced component level diagnostic messages. Sophisticated backtracing routines were not needed to determine with significant probability that a component or components would fail during operation. In U.S. Patent No. 4,588,945 methods and apparatus are disclosed which prevent damage to such DUTs or upstream devices.

The present invention focuses on improvements to the driver module circuitry of in-circuit testing devices such as that disclosed in U.S. Patent No. 4,588,945 and of functional testing devices. As discussed in that patent, the driver module is made up of a multiplicity of identical driver circuits which generate the actual voltage signals provided to selected probes or nails in the test bed or bed of nails. These circuits each provide logic high, logic low and an "off" state, i.e. the so-called tri-state. Unfortunately, these driver circuits have some problems. The problems associated with such prior driver circuits are that typically the number of components utilized resulted in a relatively high cost and the practice of saturating the output transistors in less expensive drivers imposed severe limits on bandwidth.

Summary of the Invention

The advantages of the invention are achieved in a driver circuit for use in an overdrive/functional tester, which tester provides a control signal representative of a command for the driver circuit to provide signals, is shown to include a driver for providing desired logic signals in response to an actuation signal and a pre-driver, connected to receive the control signal and to the driver for generating an actuation signal in response to the control signal. The pre-driver is shown to have two fast, gold doped, switching transistors.

Brief Description of the Drawings

Fig. 1 is a schematic drawing of a driver circuit in accordance with the present invention; and

Fig. 2 is an alternative embodiment of the driver circuit shown in Fig. 1.

Detailed Description

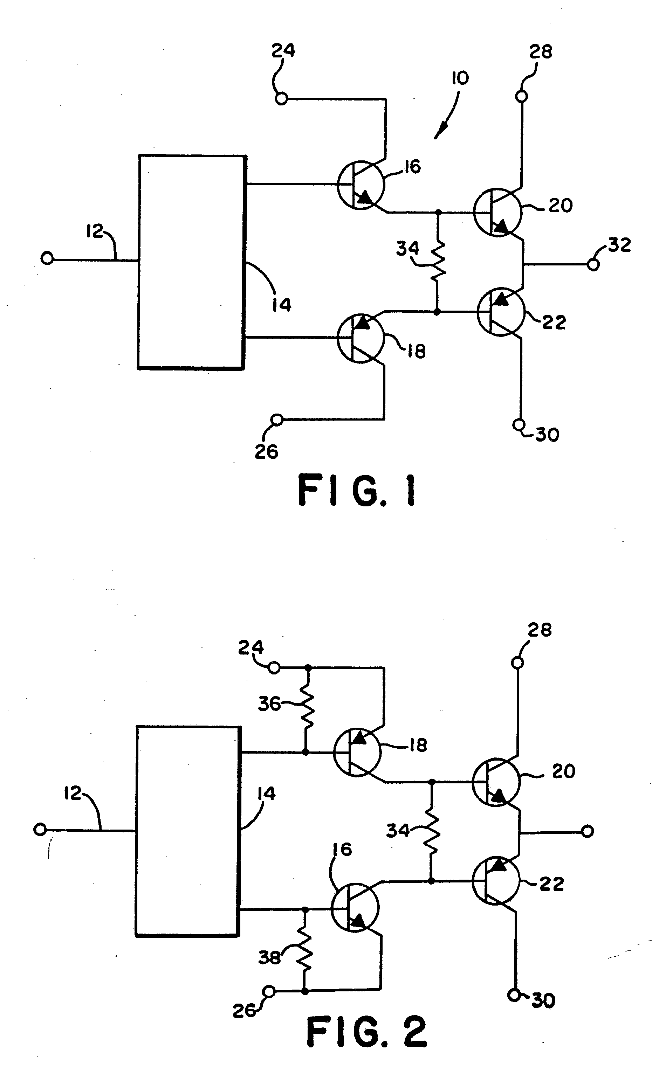

A new and novel driver circuit is shown in Fig. 1 and is generally designated 10. A pregenerated pattern or control signal is provided to input 12 from any suitable test controller module (not shown). The pattern at 12 is provided to amplifier 14 which serves to provide the gain and level shift stages of the driver circuit. Since any one of several known amplifiers will be sufficient for the purposes of the invention, the details of this device are not shown.

Driver circuit 10 is composed of two output stages, a pre-driver stage and a driver stage. It has been discovered that by the use of high speed, typically gold doped, transistors as a pre-drive stage in conjunction with an emitter follower transistor arrangement in the drive stage, the output currents necessary can be maintained while at the same time providing good speed. The speed is achieved in this circuit because the driver stage is never saturated and the pre-driver stage has the ability to move in and out of saturation very quickly. To this end there are shown in Fig. 1 two transistors 16 and 18 constituting the pre-drive stage and two transistors 20 and 22 constituting the driver stage or high current stage.

Transistor 16 has its collector connected to a supply voltage at point 24, which in the preferred embodiment is a stiff positive voltage, i.e. the supply voltage will not vary as the load current varies. The emitter of transistor 16 is connected to the base of transistor 20. The collector of transistor 18 is connected to a supply voltage at point 26, which in the preferred embodiment is a stiff negative voltage. The emitter of transistor 18 is connected to the base of transistor 22. Transistor 20 has its collector connected to Vpp at point 28. In the preferred embodiment, Vpp is a supply voltage of a nominal positive 12V. Transistor 22 has its collector connected to Vpm at point 30. In the preferred embodiment, Vpm is a supply voltage of a nominal negative 10V. The emitters of transistors and 22 are connected together and such connection constitutes the driver circuit output at point 32.

In the preferred embodiment transistor 16 is an npn switching transistor having the designation MPS2369 and transistor 18 is a pnp switching transistor having the designation 2N5771. These transistors are fast, gold doped, complementary transistors. In the preferred embodiment, transistor 20 is a 2N4401 and transistor 22 is a 2N4403. While other similar transistors may exist which can be substitutes for the preferred transistors, such substitutes should exhibit the following properties: high current capability at low Vce, sufficiently high bandwidth to provide fast output swings, high enough gain to reach high output currents without the need for excessive base current, and high breakdown voltage for protection from abuse. It should also be noted that the selection of the preferred transistors also provides sufficient speed required for functional testing.

A resistor 34 is provided between the bases of transistors 20 and 22. Resistor 34 will aid in the turn "off" of these transistors because it serves to pull the base voltage of each transistor toward its respective emitter voltage.

Consider now circuit 10 during operation. Assume that it is desired to overdrive with a positive pulse the DUT. Initially circuit 10 is in the tri-state, a high impedance "off" state. In this state the control signal supplied to amplifier 14 causes zero current to be applied to transistors 16 and 18, which in turn results in no current being applied to the bases of transistors 20 and 22. Consequently, the driver stage output is "off" or in tri-state.

When it is desired to provide a logic high output to output 32, an appropriate control signal is provided to amplifier 14. This control signal results in current being applied to the base of transistor 16 which in turn supplies a voltage to the base of transistor 20. When a voltage is applied to the base of transistor 20, a logic high output is provided at output 32. Operation of the pnp transistors is identical except that the voltages are reversed.

Fig. 2, discloses an alternative embodiment to the driver circuit of Fig. 1. It will be noted that the circuit of Fig. 2 is identical to that of Fig. 1 except that the arrangement of transistors 18 and 16 has been reversed and resistors 36 and 38 have now been provided between the base and emitter of transistors 18 and 16, respectively. The circuit operates identical to Fig. 1. However, this embodiment may make the design of the front end amplifier/level shift, i.e. amplifier 14, more easily accomplished. Additionally, the provision of resistors 36 and 38 serves to make the base/emitter voltage zero when the transistor is turned "off". While the invention has been described and illustrated with reference to specific embodiments, those skilled in the art will recognize that modification and variations may be made without departing from the principles of the invention as described herein above and set forth in the following claims.

## Claims

1. A driver circuit (10) for use in an overdrive/functional tester, which tester provides a control signal representative of a command for said driver circuit to provide logic signals, comprising: driver means (20,22) for providing desired logic signals in response to an actuation signal; and pre-driver means (16,18), connected to receive said control signal and to said driver means (20,22), for generating an actuation signal in response to said control signal.

2. The driver circuit of claim 1, wherein said pre-driver stage is comprised of at least one fast switching transistor (16).

3. The driver circuit of claim 2, wherein said pre-driver circuit comprises two transistors (16,18) wherein said transistors are gold doped.

4. The driver circuit of claim 1, wherein said driver stage is comprised of two emitter follower arranged transistors (20,22).

5. The driver circuit of claim 4, wherein a resistor (34) is connected between the bases of said transistors (20,22).

6. The driver circuit of claim 2, further comprising a resistor (36) connected between the base and emitter of said transistor (18).

FIG. 1

FIG. 2